Europäisches Patentamt

European Patent Office

Office européen des brevets

(11) Publication number: **0 571 737 A1**

## EUROPEAN PATENT APPLICATION

(21) Application number: 93104876.3

(22) Date of filing: 24.03.93

(51) Int. Cl.5: **G06K 15/12**, B41J 2/45, H01L 33/00, H03K 3/017

(30) Priority: 29.05.92 JP 139419/92

(43) Date of publication of application:
01.12.93 Bulletin 93/48

(84) Designated Contracting States:
DE FR GB

(71) Applicant: **Kabushiki Kaisha Toshiba**
**72, Horikawa-cho**
**Saiwai-ku**
**Kawasaki-shi(JP)**

(72) Inventor: **Nakamura,Hajiime, c/o**
**Intell.Property Div.**
**K.K. Toshiba,**
**1-1 Shibaura 1-chome**
**Minato-ku, Tokyo 105(JP)**

(74) Representative: **Lehn, Werner, Dipl.-Ing. et al**
**Hoffmann, Eitle & Partner,**
**Patentanwälte,**
**Postfach 81 04 20**
**D-81904 München (DE)**

(54) Image forming apparatus.

(57) An image forming apparatus permits improving the light intensity distribution in the main scanning direction including the nonuniform light intensity derived from an optical means such as a Selfoc lens array. The apparatus comprises a plurality of edge emitter type EL light emitting elements (11a-11g). In these light emitting elements (11a-11g), the thicknesses of the light emitting layers (12a-12g) are determined to correspond to the nonuniform intensity distribution of the light beams after transmission through a Selfoc lens array used in combination with the EL light emitter array (10). Specifically, an EL light emitting element (11a-11g) having a thick light emitting layer (12a-12g) is arranged in a position corresponding to the position of a Selfoc lens which causes the light beam transmitted therethrough to have a low intensity. In other words, an EL light emitting element (11a-11g) which emits a light beam having a high intensity is arranged in a position corresponding to the position of the particular Selfoc lens noted above such that a light beam having a high intensity is guided to a Selfoc lens causing the light beam transmitted therethrough to have a low intensity. Likewise, an EL light emitting element (11a-11g) having a thin light emitting layer (12a-12g) is arranged in a position corresponding to the position of a Selfoc lens which causes the light beam transmitted therethrough to have a high intensity.

FIG. 1 D

LIGHT INTENSITY DISTRIBUTION IN MAIN SCANNING DIRECTION ON IMAGE-FORMING PLANE

DISTANCE

The present invention relates to an image forming apparatus adapted for a line printer called an edge emitter type electroluminescent (EL) printer, which prints an image by an electrophotographic system using a printing head including an edge emitter type EL array as a light source.

A line printer utilizing an electrophotographic system has been developed in recent years. In the line printer, devices such as a charger, linearly arranged printing heads, a developer and a transfer device are arranged around a photosensitive drum. The photosensitive drum is charged by the charger to selectively enable light emitting elements mounted to the printing heads to emit light. As a result, a circumferential surface of the photosensitive drum is exposed to light to form an electrostatic latent image. The latent image thus formed is developed by a toner supplied from the developer. Further, the resultant toner image is transferred onto a paper sheet by the transfer device.

In general, a light-emitting diode is used as the light emitting element mounted to the printing head. However, it is difficult for the light-emitting diode to meet simultaneously the requirements of a high intensity of the light emitted therefrom and a high response speed. To overcome the difficulty, vigorous studies are being made nowadays on the use of an edge emitter type EL light emitting element in the printing head. Since the edge emitter type EL light emitting element is formed in general by the thin film technology, the element is known to emit a light beam of an intensity higher than that of the light beam emitted from the surface emitter type light emitting element. The intensity of the light beam emitted from the edge emitter type light emitting element is changed depending on the thickness of the element.

The edge emitter type EL light emitting element is described in, for example:

1. TFEL EDGE EMITTER ARRAY FOR OPTICAL IMAGE BAR APPLICATIONS - Zolten K.Kun et al., Proc. SID,28/l, PP81-85 (1987), and
2. GRAY SCALE AND RESOLUTION CAPABILITIES OF EDGE EMITTER IMAGING STATIONS - Zolten K.Kun et al., -JAPAN SOCIET OF APPLIED PHYSICS, KANSAI SECTION, SYMPOSIUM 9-17-91, UMEDA OSAKA

EL light emitting elements are linearly arranged in the main scanning direction. A technique of improving the uniformity in the distribution of the intensities of the light beams emitted from these EL light emitting elements is disclosed in, for example, Published Unexamined Japanese Patent Application No. 3-90370. Specifically, this prior art teaches that the intensities of the light beams emitted from the linearly arranged-EL light emitting elements are measured and, based on the measured values, the EL light emitting elements are partly removed to achieve a uniform light intensity.

Another improvement in the case where EL light emitting elements are mounted to a recording head of a printer is proposed in, for example, Published Unexamined Japanese Patent Application No. 3-259274. Specifically, it is proposed that a light sensor is arranged on the outer circumferential surface of a photosensitive drum to measure the intensities of the light beams emitted from the EL light emitting elements. Based on the measured values, the voltage applied to the EL light emitting elements is changed to achieve a uniform light intensity distribution.

A technique for improving the light emitting efficiency of an edge emitter type EL light emitting element is disclosed in, for example, Published Unexamined Japanese Patent Application No. 2-184467. Specifically, this prior art proposes to mount an optical waveguide on the edge surface of the EL light emitting element.

Further, it is proposed in Published Unexamined Japanese Patent Application No. 3-173658 that, in order to improve the rising characteristics in the light emission of an EL light emitting element, light is emitted from the element and, then, the next light emission is started before vanishment of the afterglow of the previous light emission.

Proposed in the prior art is an edge emitter head, in which the light beams emitted from edge emitter type EL light emitting elements are guided by a Selfoc lens array (trade name of Nihon Itaglass K.K.) onto a photo-sensitive body to form an image thereon. In the optical system using the Selfoc lens array, however, the images formed by the Selfoc lens elements overlap with each other. What should be noted is that the Selfoc lens element has a light intensity distribution shaped like a half of a football. It follows that the optical system utilizing the Selfoc lens array gives rise to a problem that a periodic light intensity distribution relating to the pitch of the lens arrangement is brought about. Where EL light emitting elements are used in combination with Selfoc lenses, the uniformity of the light intensity in the main scanning direction is impaired by the nonuniform light intensity distribution inherent in the Selfoc lens, with the result that the quality of the printed material is lowered in the case of, particularly, printing of an intermediate gradation.

As described previously, Published Unexamined Japanese Patent Application No. 3-90370 teaches that the distribution in the intensities of the light beams emitted from EL light emitting elements is measured for correcting the light intensity distribution. Even if the light intensity distribution is corrected in this fashion, it is impossible to overcome the nonuniform light intensity derived from the use of Selfoc lenses. Further, an additional labor is required for further processing the EL light emitting element once formed by, for example, a thin film technology.

Further, it is proposed in Published Unexamined Japanese Patent Application No. 3-259274 that a light sensor is arranged on the outer circumferential surface of a photosensitive drum and the intensities of the light beams emitted from the EL light emitting elements are controlled based on the measured values, as described previously. The particular technique makes it possible to maintain the light intensity inherent in the EL light emitting element even after deterioration of the EL light emitting element. However, it is impossible in principle to detect the intensity of the light emitted from the EL light emitting element itself used for forming a latent image on a photosensitive body. Further, where the detecting section of the light sensor is contaminated with the scattering developing agent, it is impossible to detect accurately the light intensity, with the result that an excessively high voltage tends to be applied to the EL light emitting element.

On the other hand, the edge emitter type EL light emitting element, which certainly permits emitting light of intensity higher than that of the light emitted from the surface emitter type element, is poor in the rising characteristics of light emission after the voltage application. To overcome the difficulty, it is proposed that the EL light emitting element be operated to start a light emitting function before vanishment of the afterglow of the previous light emission.

However, it is practically difficult to employ the particular technique because, where the previous image data does not necessitate light emission, the EL light emitting element corresponding to said image data does not emit light. To be more specific, in performing a printing operation from, for example, white to black including the case where the EL light emitting element does not emit light, the poor rising characteristics of the light emission are not improved.

To reiterate, the EL light emitting element is poor in its rising characteristics of the light emission. Also, afterglow remains after the voltage application is turned off. It follows that, where a photosensitive body is driven by a pulse motor, a synergetic effect is produced by a change in concentration between lines of the edge emitter type EL array and a change in the pulse motor speed, giving rise to a nonuniform printing concentration in the sub-scanning direction.

An object of the present invention is to provide an image forming apparatus which permits improving the light intensity distribution in the main scanning direction including a nonuniform light intensity distribution derived from an optical system such as a Selfoc lens array.

Another object is to provide an image forming apparatus which permits improving the rising characteristics of light emission from an edge emitter type light emitting element.

Still another object is to provide an image forming apparatus which permits detecting deterioration of an edge emitter type light emitting element and also permits correcting a change in the light intensity caused by the deterioration of the light emitting element.

According to a first aspect of the present invention, there is provided an image forming apparatus for forming an image on an image bearing member, comprising:

optical guide means for guiding a light beam to the image bearing member so as to irradiate a linear region of the image bearing member, the optical guide means having light transmitting characteristics which permit the linear region to be irradiated with a first periodic and nonuniform light intensity distribution; and

means for emitting the light beam so as to irradiate the optical guide means, the emitting means, having a plurality of edge emitter type light emitting elements which are linearly arranged and emit light from the edge surface on the basis of an electroluminescence phenomenon toward the guide means, for emitting a light beam of a second periodic and nonuniform intensity dependent on the first intensity distribution so as to achieve a substantially uniform light intensity distribution in the linear region of the image bearing member.

According to a second aspect of the present invention, there is provided an image forming apparatus for forming an image on an image bearing member, comprising:

optical guide means for guiding a beam to the image bearing member so as to irradiate a linear region of the image bearing member, the optical guide means having light transmitting characteristics which permit the linear region to be irradiated with a light intensity distribution having a nonuniform period;

means for emitting the light beam so as to irradiate the optical guide means, the emitting means having a plurality of edge emitter type light emitting elements which are linearly arranged and emit light from the edge surface on the basis of an electroluminescence phenomenon toward the guide means; and

means for transmitting the light beams guided by the optical guide means so as to correct the nonuniform light intensity distribution of the optical guide means.

This invention can be more fully understood from the following detailed description when taken in conjunction with the accompanying drawings, in which:

Fig. 1A is an oblique view schematically showing an edge emitter type EL light emitter array which is incorporated in a printing head of an image forming apparatus according to one embodiment of the present invention;

Fig. 1B is a graph showing the light intensity distribution of the edge emitter type EL light emitter array shown in Fig. 1A;

Fig. 1C is a graph showing a nonuniform intensity distribution of the light beam, said distribution being based on the light transmitting characteristics of a Selfoc lens array serving to guide the light beams emitted from the edge emitter type EL light emitter array shown in Fig. 1A;

Fig. 1D is a graph showing the light intensity distribution in the main scanning direction on a plane exposed to the light emitted from the edge emitter type EL light emitter array shown in Fig. 1A, which is incorporated in a printing head included in an image forming apparatus according to a modification of the present invention;

Fig. 2A is an oblique view schematically showing an edge emitter type EL light emitter array which is incorporated in a printing head of an image forming apparatus according to another embodiment of the present invention;

Fig. 2B is a graph showing the light intensity distribution of the edge emitter type EL light emitter array shown in Fig. 2A;

Fig. 2C is a graph showing a nonuniform intensity distribution of the light beam, said distribution being based on the light transmitting characteristics of a Selfoc lens array serving to guide the light beams emitted from the edge emitter type EL light emitter array shown in Fig. 2A;

Fig. 2D is a graph showing the light intensity distribution in the main scanning direction on a plane exposed to the light emitted from the edge emitter type EL light emitter array shown in Fig. 2A, which is incorporated in a printing head included in an image forming apparatus according to a modification of the present invention;

Fig. 3A is an oblique view schematically exemplifying an edge emitter type EL light emitter array which is incorporated in a printing head for showing a light intensity distribution on a light-exposed plane in the case where the intensity distribution of the light emitted from the edge emitter type EL light emitter array is combined in a certain phase of arrangement with a nonuniform light intensity distribution brought about by the light transmitting characteristics of a Selfoc lens array;

Fig. 3B is a graph showing the light intensity distribution of the edge emitter type EL light emitter array shown in Fig. 3A;

Fig. 3C is a graph showing a nonuniform intensity distribution of the light beam, said distribution being based on the light transmitting characteristics of a Selfoc lens array serving to guide the light beams emitted from the edge emitter type EL light emitter array shown in Fig. 3A;

Fig. 3D is a graph showing the light intensity distribution in the main scanning direction on a plane exposed to the light emitted from the edge emitter type EL light emitter array shown in Fig. 3A, which is incorporated in a printing head included in an image forming apparatus according to a modification of the present invention;

Fig. 4A is an oblique view schematically exemplifying an edge emitter type EL light emitter array which is incorporated in a printing head for showing a light intensity distribution on a light-exposed plane in the case where the intensity distribution of the light emitted from the edge emitter type EL light emitter array is combined in another certain phase of arrangement with a nonuniform light intensity distribution brought about by the light transmitting characteristics of a Selfoc lens array;

Fig. 4B is a graph showing the light intensity distribution of the edge emitter type EL light emitter array shown in Fig. 4A;

Fig. 4C is a graph showing a nonuniform intensity distribution of the light beam, said distribution being based on the light transmitting characteristics of a Selfoc lens array serving to guide the light beams emitted from the edge emitter type EL light emitter array shown in Fig. 4A;

Fig. 4D is a graph showing the light intensity distribution in the main scanning direction on a plane exposed to the light emitted from the edge emitter type EL light emitter array shown in Fig. 4A, which is incorporated in a printing head included in an image forming apparatus according to a modification of the present invention;

Fig. 5 is a plan view showing a printing head unit using a printing head having an edge emitter type EL light emitter array incorporated therein, said printing head unit being included in an image forming apparatus according to another embodiment of the present invention;

Figs. 6A and 6B are a front view and a bottom view, respectively, showing in detail a region of the Selfoc lens array unit incorporated into the printing head unit shown in Fig. 5;

Fig. 7A is a front view showing a modification of the printing head unit according to one embodiment of the present invention;

Fig. 7B is a bottom view showing a Selfoc lens array unit which is incorporated into the printing head unit shown in Fig. 7A;

Fig. 8A is a graph showing a periodic nonuniform light intensity distribution based on the light transmitting characteristics of the Selfoc lens array;

Fig. 8B is a graph showing a distribution of the light transmittance of an optical filter for correcting the nonuniform light intensity distribution;

Fig. 9 is a side view, partly broken away, which schematically shows another modification of a printing head of the present invention having an edge emitter type EL light emitter array incorporated therein;

Fig. 10 is an oblique view schematically showing another modification of a printing head of the present invention having an edge emitter type EL light emitter array incorporated therein;

Fig. 11 is a side view schematically showing the printing head shown in Fig. 10;

Figs. 12A, 12B, 12C and 12D are timing charts showing changes with time in the driving voltage of the printing head and in the intensity of the emitted light;

Fig. 13 is a side view showing another modification of a printing head of the present invention having an edge emitter type EL light emitter array shown in Fig. 10 incorporated therein;

Figs. 14A, 14B and 14C are timing charts showing changes with time in the driving voltage of the printing head shown in Fig. 13 and in the intensity of the emitted light;

Fig. 15 is a timing chart for explaining how to drive the printing head of the present invention;

Fig. 16 is a timing chart for explaining how to drive the printing head of the present invention;

Fig. 17 is a graph showing the relationship between the voltage applied to the printing head of the present invention and the brightness of the emitted light;

Fig. 18 is a graph showing the relationship between the input pulse supplied to the printing head of the present invention and the brightness of the emitted light;

Fig. 19 is a cross sectional view schematically showing a printer of the present invention;

Fig. 20 is a block diagram showing the control section included in the printer shown in Fig. 19;

Fig. 21 is a block diagram showing the driving circuit of a printing head of the present invention;

Figs. 22A and 22B are timing charts for explaining the light emission/non-emission control employed in the printing head of the present invention;

Figs. 23A, 23B, 23C and 23D are timing charts collectively showing how to achieve synchronism between the light emission from the printing head and the driving of the photosensitive drum in the image forming apparatus of the present invention;

Fig. 24 is an equivalent circuit diagram showing an edge emitter type EL light emitter array and a discharge current detecting circuit employed in the present invention;

Fig. 25 is a block diagram showing an another driving circuit of a printing head of the present invention;

Figs. 26A, 26B and 26C are timing charts for explaining the light emission/non-emission control employed in the circuit shown in Figs. 21 and 25 incoparated in the printing head of the present invention, when the common pulse shown in Fig. 15 is applied to the common electrodes; and

Figs. 27A, 27B and 27C are timing charts for explaining the light emission/non-emission control employed in the circuit shown in Figs. 21 and 25 incoparated in the printing head of the present invention, when the common pulse shown in Fig. 16 is applied to the common electrodes.

Let us describe an image forming apparatus of the present invention with reference to the accompanying drawings. An edge emitter type EL printer is one of the image forming apparatus of the present invention. Let us describe a printing head having an edge emitter type EL light emitter array incorporated therein, said printing head being included in the edge emitter type EL printer.

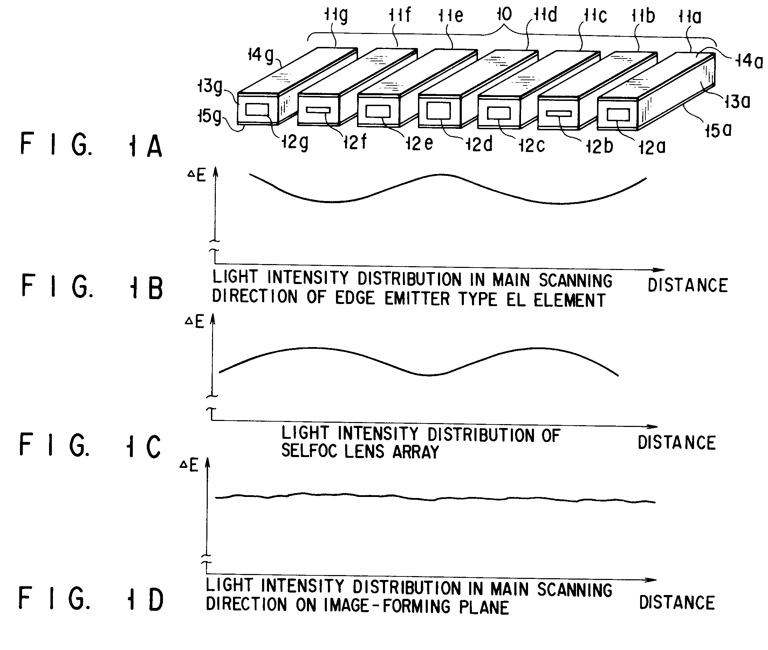

Fig. 1A shows a printing head formed of an array of EL light emitting elements which are arranged linearly in the main scanning direction. A light beam is emitted from the edge surface of each of these EL light emitting elements. In the array shown in the drawing, these EL light emitting elements differ from each other in the thickness of the light emitting layer to permit correction of the nonuniform intensity distribution of the light beams transmitted through a Selfoc lens array.

The drawing of Fig. 1A shows an edge emitter type EL light emitter array 10 of a printing head, EL light emitting elements 11a to 11g which are linearly arranged and emit light beams from the edge surfaces, light emitting layers 12a to 12g of the EL light emitting elements, said layers 12a to 12g differing from each other in thickness, dielectric layers 13a to 13g of the EL light emitting elements, upper electrodes or channel electrodes 14a to 14g of the EL light emitting elements, and lower electrodes or common electrodes 15a to 15g of the EL light emitting elements.

In the edge emitter type EL light emitting elements 11a to 11g, the thicknesses of the light emitting layers are determined to correspond to the nonuniform intensity distribution of the light beams after transmission through a Selfoc lens array used in combination with the EL light emitter array 10. To be more specific, an EL light emitting element having a thick light emitting layer is arranged in a position corresponding to the position of a Selfoc lens which causes the light beam transmitted therethrough to have a low intensity. In other words, an EL light emitting element which emits a light beam having a high intensity is arranged in a position corresponding to the position of the particular Selfoc lens noted above such that a light beam having a high intensity is guided to a Selfoc lens causing the light beam transmitted therethrough to have a low intensity. Likewise, an EL light emitting element having a thin light emitting layer is arranged in a position corresponding to the position of a Selfoc lens which causes the light beam transmitted therethrough to have a high intensity.

Naturally, the light emitting area is increased physically, if the thickness of the light emitting layer is increased. In addition, the intensity of the light beam emitted from the EL light emitting element can be increased by increasing the thickness of the light emitting layer, as described in publications 1 and 2 referred to previously. This has also been confirmed experimentally.

Suppose the printing is performed on a paper sheet of, for example, A4 size with a printing density of 300 dots/inch in this embodiment. Needless to say, the resolution of the printing density and the size of the recording paper sheet need not be restricted in the present invention to the values exemplified above. Where the printing is performed with a printing density of 300 dots/inch, the EL light emitting elements are arranged with a pitch of about 85 $\mu$m. On the other hand, the nonuniformity in the intensity of the light transmitted through a Selfoc lens is generally represented by formula (1) given below:

$$E(X) = E0_1 - (X/X0) \qquad (1)$$

wherein X is a distance between a position on a line perpendicular to the optical axis of Selfoc lens and the optical axis, E(X) is an intensity on the position apart from an optical axis of an image forming plane of the Selfoc lens at a distance X, E0 is an intensity on the optical axis of Selfoc lens, and X0 is a radius of a beam spot which is formed on the image forming plane, which is determined depending on an aperture angle of Selfoc lens.

The pitch in the nonuniformity of the light intensity in the Selfoc lens array can be calculated from formula (1) and the arrangement of the Selfoc lenses, though the pitch depends on the overlapping degree of the images formed by the Selfoc lenses and the number of rows of the Selfoc lens array. To be more specific, it has been confirmed experimentally that the pitch in the nonuniformity of the light intensity on the image forming plane is about 1.5 mm in the case where the light beams emitted from the EL light emitting elements run through the Selfoc lenses to form images. It follows that it suffices to determine appropriately a segment, i.e., the thickness of the light emitting layer, such that one period is formed by about 17 segments.

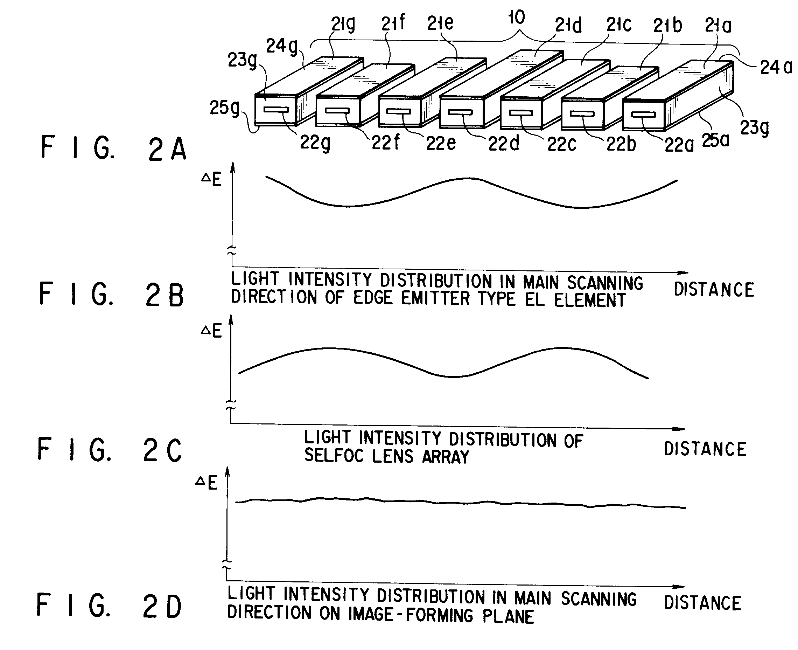

Fig. 2A shows a modification of a printing head using edge emitter type EL light emitting elements. In this case, the light emitting layer included in the edge emitter type EL light emitting elements are made different from each other in length in place of changing the thickness of the light emitting layer as in the embodiment shown in Fig. 1A. As a result, the distribution of the light intensity in the main scanning direction can be improved in the embodiment of Fig. 2A as in the embodiment of Fig. 1A. It is described in publications 1 and 2 referred to previously that the intensity of the light beam emitted from the edge emitter type EL light emitting element can be controlled by changing the length of the light emitting layer of the element. In addition, this has already been confirmed experimentally. Incidentally, the drawing of Fig. 2A shows an edge emitter type EL light emitter array 10 included in a printing head, edge emitter type EL light emitting elements 21a to 21g, light emitting layers 22a to 22g differing from each other in length, dielectric layers 23a to 23g, upper or channel electrodes 24a to 24g, and lower or common electrodes 25a to 25g.

As described above with reference to Figs. 1A to 2D, the light intensity distribution in the main scanning direction can be made uniform on the image forming plane of the printing head as shown in Figs. 1D and 2D by determining appropriately the light intensity distribution of the edge emitter type EL light emitting elements as shown in Figs. 1B and 2B so as to offset the light intensity distribution of the Selfoc lens array.

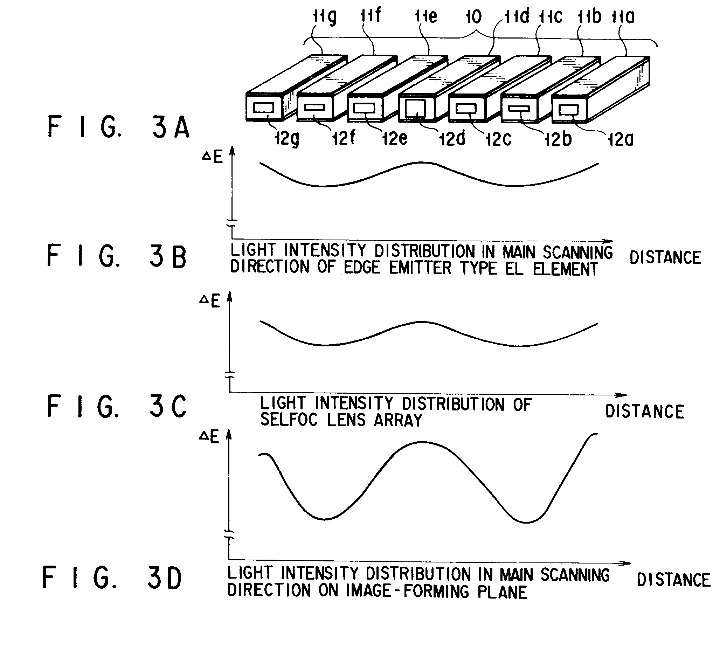

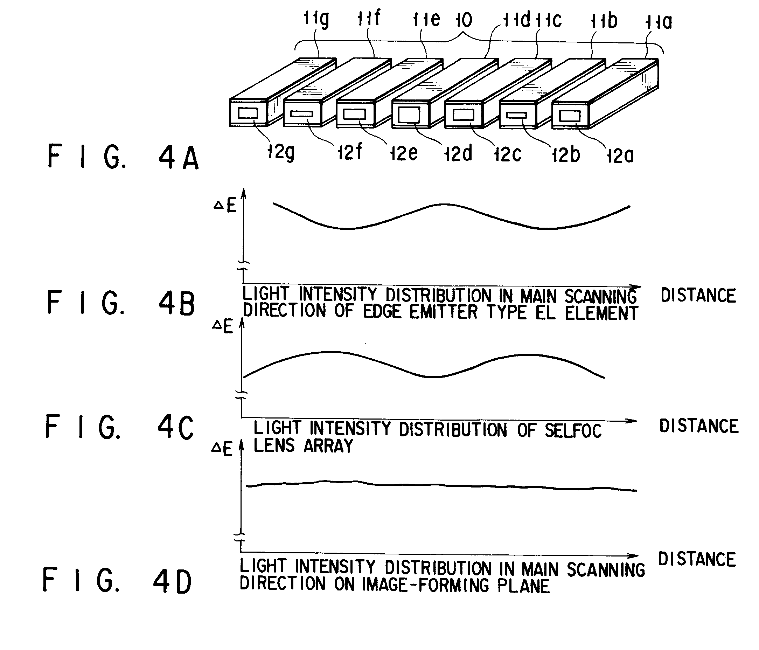

It should be noted that, even if the light intensity distribution of the edge emitter type EL light emitter array is adjusted to correspond to the nonuniform light intensity distribution of the Selfoc lens array, the nonuniformity in the light intensity distribution on the image forming plane is amplified as shown in Figs. 3A to 3D, in the case where the nonuniform distribution for the EL light emitter array coincides with the nonuniform distribution for the Selfoc lens array. The problem can be overcome by optimizing the combination of the light intensity distributions for the EL light emitter array and the Selfoc lens array, as shown in Figs. 4A to 4D.

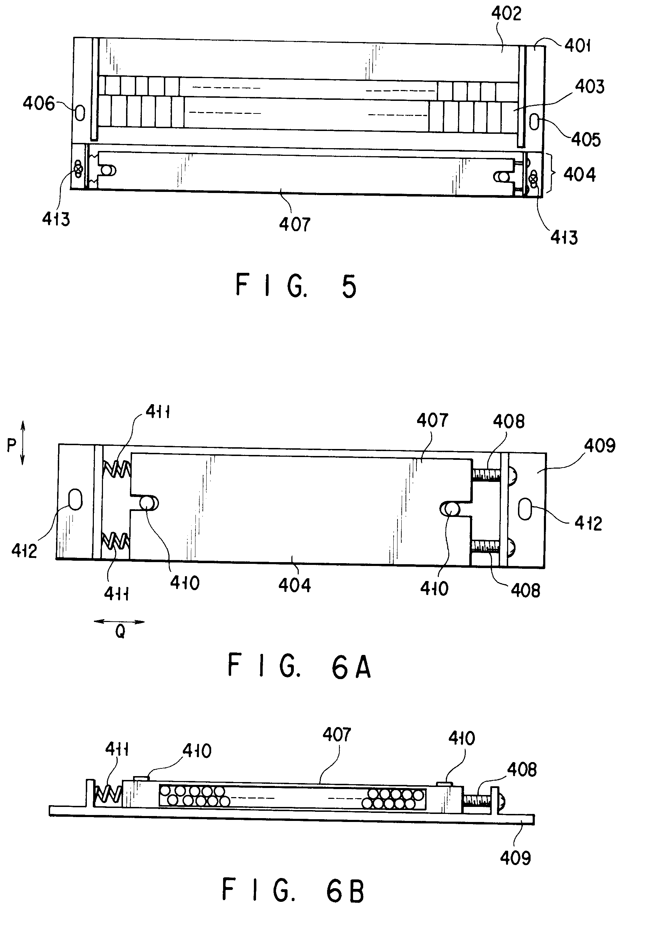

Figs. 5, 6A and 6B collectively show a printing head unit in which is incorporated the edge emitter type EL light emitter array described above. As seen from these drawings, the printing head unit comprises a base member 401. Mounting holes 405 and 406 for mounting the printing head unit to a printer are formed in the base member 401. Incorporated in the base member 401 are a driving circuit 402 of the EL light emitter array, edge emitter type EL light emitter array 403, which corresponds to the edge emitter type EL light emitter array 10 shown in each of Figs. 1A and 2A, Selfoc lens array unit 404, etc.

The Selfoc lens array unit 404 is fixed to the base member 401 by a fixing screw 413. In this case, oblong holes 412 are formed in a Selfoc lens unit base 409. The fixing screws 413 are inserted into these oblong holes for fixing the Selfoc lens array unit to the base member 401. It should be noted that the particular fixing fashion permits the Selfoc lens array unit 404 to be moved in the directions denoted by arrows P, i.e., in the vertical direction, so as to adjust the focus of the Selfoc lens array 407. It follows that it is possible to make the light intensity distribution optimum in the image forming plane of the light beams emitted from the edge emitter type EL light emitter array 403.

The Selfoc lens array 407 is mounted to the Selfoc lens unit base 409 at a position determined by positioning pins 410. The Selfoc lens array 407 is made stationary in the directions P by the positioning pins 410, though the array 407 is movable in the directions denoted by arrows Q, i.e., in the horizontal directions. The Selfoc lens array 407 is pressurized by a spring 411 and its position is adjusted by an adjusting screw 408. If the pitch of the periodic nonuniformity in the light intensity of the Selfoc lens array 407 falls within a periodic range, the width of the adjustment permits sufficiently offsetting the nonuniformity in the light intensity distribution of the Selfoc lens array 407.

As described above, it is necessary to change the shape of each of the edge emitter type EL light emitting elements in a manner to correct sufficiently the nonuniformity in the light intensity distribution of the Selfoc lens array. What should be noted is that the shape noted above can be controlled as desired in the step of preparing the edge emitter type EL light emitter array by, for example, a thin film technology. It should also be noted that the nonuniformity in the light intensity distribution of the Selfoc lens array can be calculated or measured in advance depending on the construction of the array. It follows that it is unnecessary to measure the light intensity distribution of the printing head and apply an after-treatment based on the result of the measurement using, for example, a laser beam.

In the embodiments described above, the light intensity distribution of the edge emitter type EL light emitter array is changed to conform with the nonuniformity in the light intensity distribution of the Selfoc lens array. In the present invention according to another embodiment, however, it is also possible to improve the light intensity distribution in the main scanning direction without changing the light intensity distribution of the edge emitter type EL light emitter array.

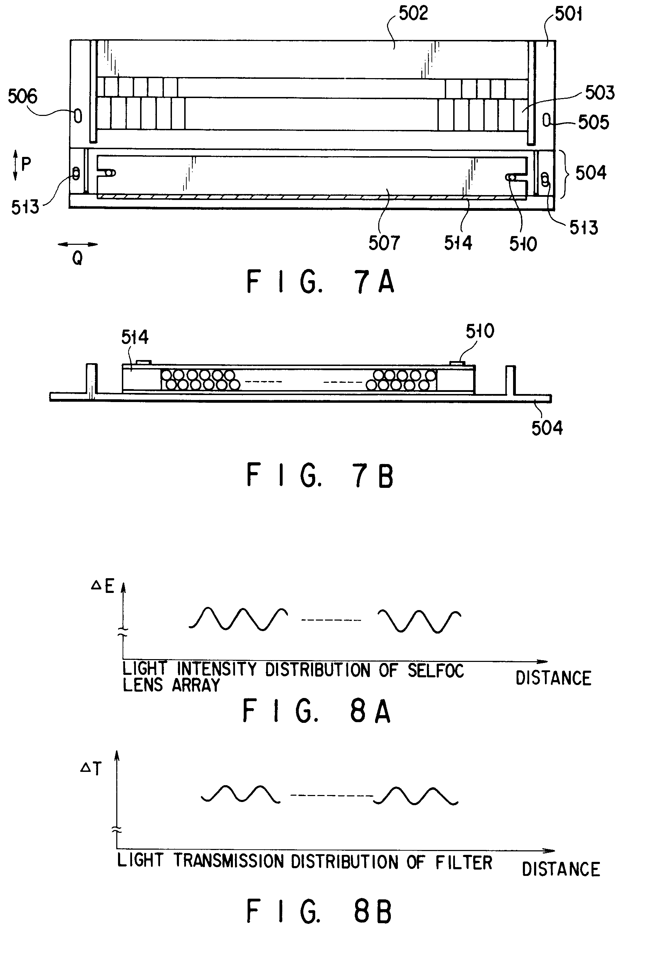

Specifically, Fig. 7A shows a printing head unit according to said "another embodiment" of the present invention. In this embodiment, a Selfoc lens unit 504 can be adjusted in the directions denoted by arrow P, i.e., in the vertical direction. A Selfoc lens 507 is fixed at a position determined by a positioning pin 510 by a method not shown in the drawing. A reference numeral 514 denotes an optical filter having a light transmittance distribution to correct the nonuniformity in the light intensity distribution of the Selfoc lens array 507. The optical filter 514 is disposed on an optical axis of the Selfoc lens array 507 in a manner to offset the nonuniform light intensity distribution of the Selfoc lens array 507, as shown in, for example, Figs. 8A and 8B. If the apparatus is constructed to permit adjustment of the relative positions of the optical filter 514 and the Selfoc lens array 507 in the directions denoted by arrows Q, though the adjusting mechanism is not shown in the drawing, the nonuniformity in the light intensity distribution can be offset more effectively, quite naturally.

The particular construction described above makes it possible to improve the uniformity in the light intensity distribution of the printing head utilizing the edge emitter type EL light emitter array. In addition, it is unnecessary to prepare edge emitter type EL light emitting elements which emit light beams having a nonuniform intensity distribution, i.e., light beams whose intensities are changed periodically.

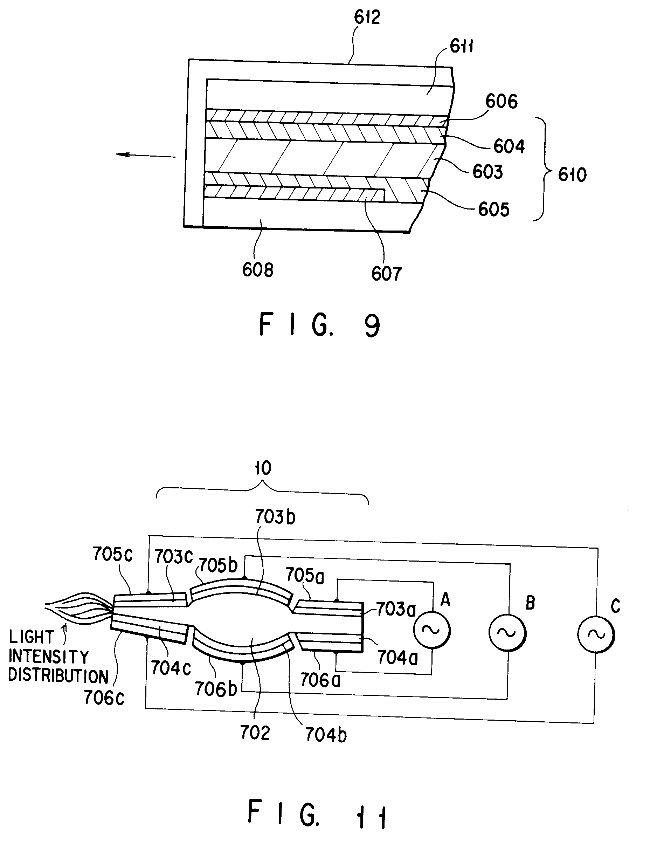

Fig. 9 shows a modification in which the nonuniformity in the light intensity distribution is corrected by a protective film included in an edge emitter type EL light emitting element. It should be noted that the edge emitter type EL light emitting element is low in its environmental resistance. Particularly, the element is deteriorated under a humid atmosphere. To overcome the difficulty, a protective film is formed to surround the edge emitter type EL light emitter array. For example, a silicone oil is sealed in the edge emitter type EL light emitter array. It is also known to the art that the protective film is formed of an opaque material so as to achieve a light shielding between adjacent segments of the light emitting elements.

In the present invention, the protective film is formed to have a light transmittance distribution which permits offsetting the nonuniformity in the light intensity distribution of the Selfoc lens array in the light emitting edge surface of the EL light emitting element. Fig. 9 shows a light emitting layer 603, dielectric layers 604, 605, an upper or channel electrode 606, a lower or common electrode 607, a substrate 608, an edge emitter type EL light emitting element 610, an upper member 611, and a protective film 612 described above.

The particular construction shown in Fig. 9 makes it possible to prevent the EL light emitting element from being deteriorated. In addition, it is possible to offset the nonuniformity in the light intensity distribution of the Selfoc lens array. It follows that it is unnecessary to add, particularly, an optical filter in an outer region.

In the embodiments described above, it is possible to improve the light intensity distribution in the main scanning direction. In addition, it is also possible to improve the change with time in the light emitting characteristics of the edge emitter type EL light emitting element in the present invention. The improvement achieved by the particular construction permits improving the characteristics in the sub-scanning direction.

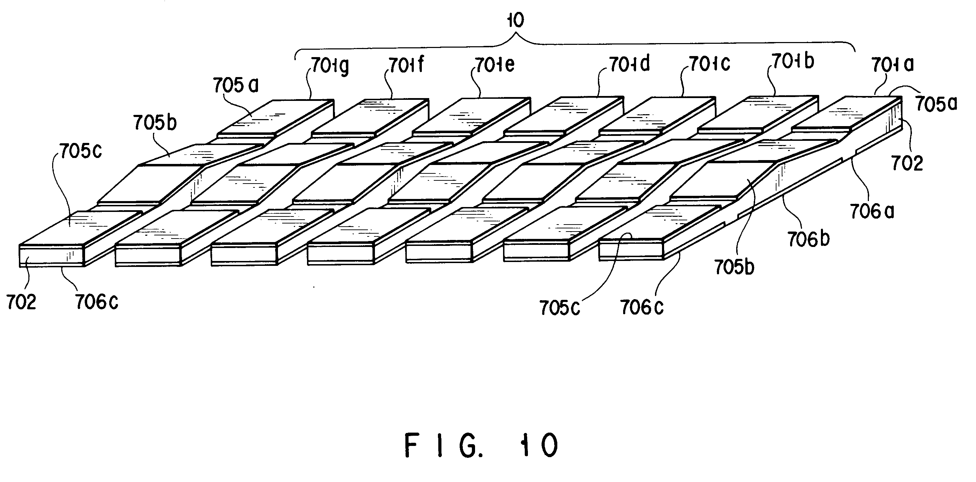

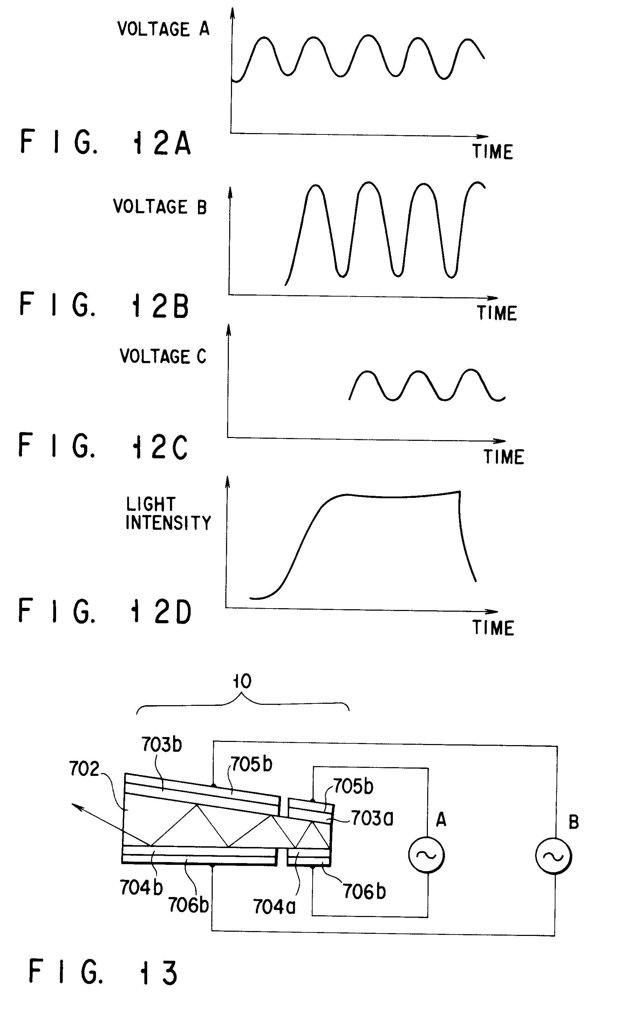

Specifically, Figs. 10 and 11 collectively show a printing head utilizing the edge emitter type EL light emitter array which permits improving the characteristics in the sub-scanning direction. The arrangement shown in Figs. 10 and 11 comprises an edge emitter type EL light emitter array 10, edge emitter type EL light emitting elements 701a to 701g, a light emitting layer 702, upper dielectric layers 703a to 703c, lower dielectric layers 704a to 704c, upper or channel electrodes 705a to 705c, and lower or common electrodes 706a to 706c. In this embodiment, each of the edge emitter type EL light emitting elements 701a to 701g is formed of three portions differing from each other in the thickness of the light emitting layer 702. As seen from the drawings, these three portions of each of the edge emitter type EL light emitting elements 701a to 701g are of a laminate structure consisting of the lower or common electrodes 706a to 706c, the light emitting layer 702, and the upper electrodes 705a to 705c, respectively.

As described in publications 1 and 2 referred to previously, the thickness of the light emitting layer is proportional to the threshold voltage for initiation of the light emission in the edge emitter type EL light emitting element. Thus, voltage A is applied between the upper and lower or common electrodes 705a and 706a. Also, voltage B is applied between the upper and lower or common electrodes 705b and 706b. Further, voltage C is applied between the upper and lower or common electrodes 705c and 706c, as shown in Fig. 11. These applied voltages A to C have a relationship as shown in, for example, Figs. 12A to 12D. It should be noted that the light beam emitted from an edge emitter type element has an intensity higher than that of the light beam emitted from a surface emitter type element. In the edge emitter type element, the light emitting layer is longer than that of a surface emitter type element. Thus, the emitted light is intensified during transfer within the light emitting layer, leading to a high intensity of the light emitted from the edge emitter type element. The particular light emitting mechanism causes the edge emitter type element to be unsatisfactory in the rising characteristics of the light emission from the edge surface after the voltage application to the electrodes, compared with the surface emitter type element.

To overcome the difficulty described above, voltage A, which is relatively low, is kept applied to the light emitting layer 702, as shown in Fig. 12A. Then, voltages B and C are successively applied as shown in Figs. 12B and 12C when light emission from the edge surface is required, so as to improve the rising characteristics in the light emission of the light emitting element. It should be noted that the light intensity required for light emission from the edge surface can be ensured by giving a sufficient thickness to the light emitting layer 702 sandwiched between the electrodes 705b and 706b.

Further, the light emitting element can be enabled to perform a light collecting function by shaping the light emitting layer 702 near the edge portion such that the thickness of the light emitting layer is gradually diminished toward the edge surface of the element. This is also supported by experimental data reported in literature.

As described above, the rising characteristics of the light emission from an edge emitter type light emitting element can be improved by dividing the light emitting layer into three portions differing from each other in thickness. To reiterate, a pair of electrodes are mounted for each of these three portions, and the light emitting element is driven in advance with a low voltage so as to improve the rising characteristics of the element. Further, the emitted light beam can be collected by forming the light emitting layer such that the thickness of the light emitting layer is gradually diminished toward the edge surface of the element, with the result that the element efficiently emits a light beam of a high intensity. Needless to say, the edge emitter type EL light emitting element of the particular construction makes it unnecessary to utilize the afterglow of the previous light emission.

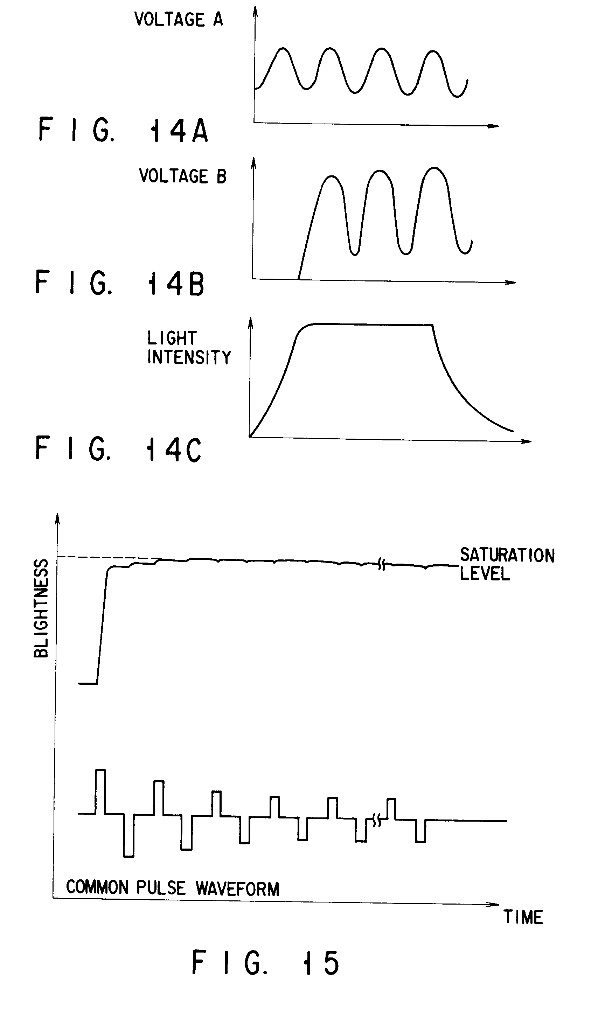

Figs. 13, 14A and 14B collectively show a modification of the printing head in which is incorporated an edge emitter type EL light emitter array with improved characteristics. In this modification, the thickness of the light emitting layer 702 is gradually increased toward the light emitting edge surface, so as to make it possible to obtain a light emission of a high intensity. It should also be noted that only two kinds of electrodes are used in this modification, leading to a simplified construction of the element. Of course, only two types of voltages are applied in this modification.

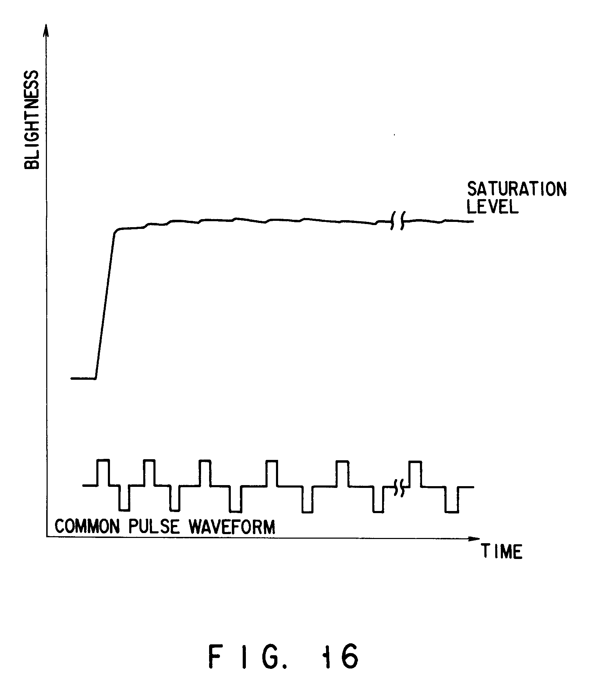

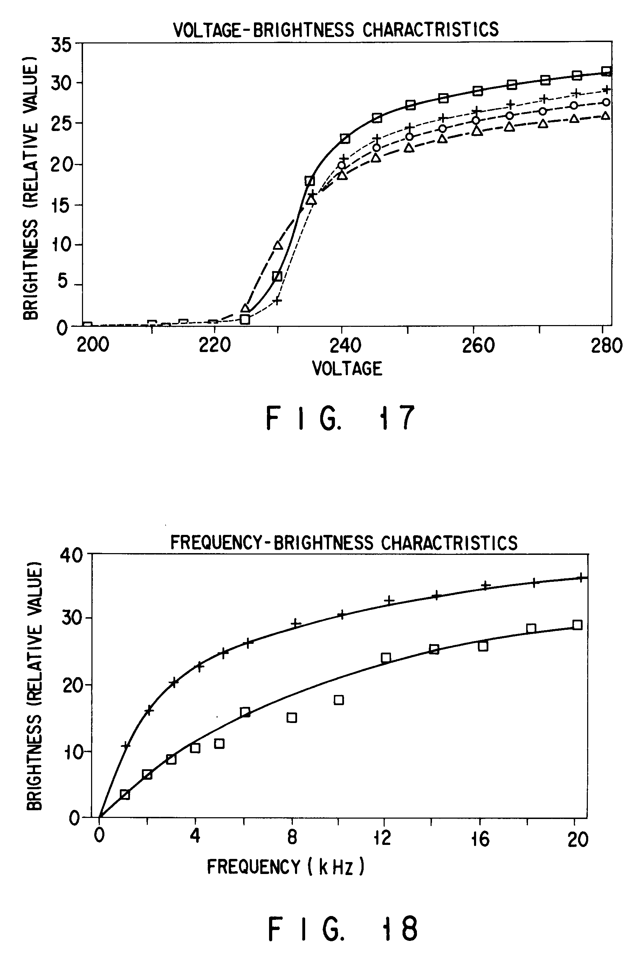

Figs. 15 and 16 show the driving method of the edge emitter type EL light emitter array used in the present invention and the timing chart showing the light emission characteristics. It is experimentally confirmed that the intensity of the light beam emitted from an edge emitter type EL light emitting element is increased in proportion to the voltage applied to the element, as shown in Fig. 17. The rising characteristics in the light emission can be improved as shown in Fig. 15 by utilizing the particular voltage-brightness relationship shown in Fig. 17. To be more specific, voltages V1, V2, V3, etc. of the relationship V1 ≥ V2 ≥ V3 ..., in which V1 denotes the voltage applied to the common electrodes at the rising stage of the light emission, and V2, V3 etc. denote the voltages applied in the succeeding stages, are applied to the edge emitter type EL light emitting element to improve the rising characteristics of the light emission as shown in Fig. 15. Further, immediately after initiation of the light emission, it is possible to obtain a light beam of an intensity close to that at the peak of the light emission. It follows that it is possible to obtain a printed image of a high quality, which readily permits an area gradation.

Fig. 18 show experimental data on the relationship between the frequency of the applied pulses and the intensities of the light beams emitted from an edge emitter type EL light emitting element. The rising characteristics of the light emission can be improved in this case, too, by applying pulses of frequencies f1, f2, f3, etc. of the relationship f1 ≥ f2 ≥ f3 ..., in which f1 denotes the frequency of the pulse voltage applied to the common electrodes at the rising stage of the light emission, and f2, f3 etc. denote the frequencies of the pulse voltages applied in the succeeding stages, to the edge emitter type EL light emitting element. In other words, the relationship T1 ≤ T2 ≤ T3 ..., is established in respect of the periods T1, T2, T3, etc. of the applied pulse voltages. Fig. 16 is a timing chart showing the driving method in the case of driving the EL light emitting element in the particular relationship shown in Fig. 18 and the intensity of the light beam emitted from the element.

The printing quality can also be improved by controlling the driving pulse of the edge emitter type EL light emitting element in synchronism with the exciting pulse of the pulse motor for driving a photosensitive drum. Let us describe an edge emitter type EL printer of the present invention directed to this particular embodiment.

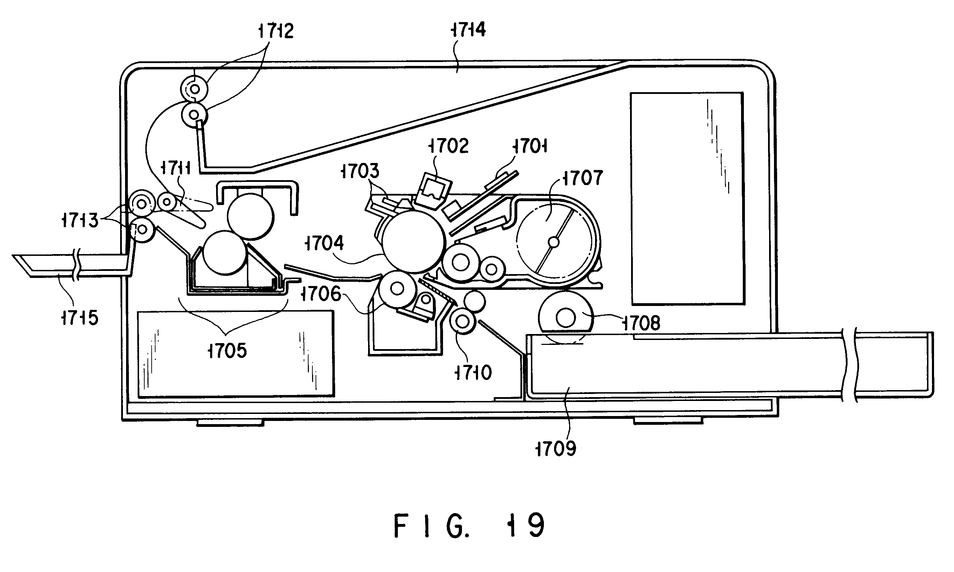

Specifically, Fig. 19 schematically shows the construction of an edge emitter type EL printer of the present invention. As shown in the drawing, a paper sheet housed in a paper feeder cassette 1709 is taken out by a paper feed roller 1708 and, then, forwarded to an aligning roller 1710. On the other hand, the surface of a photosensitive drum 1704, which is rotated by a pulse motor (not shown), is uniformly charged by a charger 1702. When a light emission control pulse, which is based on a printing image data, is supplied from a controller (not shown) to an edge emitter type EL light emitter array included in a printing head unit 1701, a plurality of EL light emitting elements included in the edge emitter type EL light emitter array are selectively allowed to emit light beams based on the light emission control pulse. As a result, an electrostatic latent image is formed on the surface of the photosensitive drum 1704.

A toner is supplied by a developer 1707 onto the surface of the photosensitive drum 1704 so as to develop the electrostatic image formed on the photosensitive drum. The toner image formed on the photosensitive drum 1704 is transferred by a transfer roller 1706 onto a paper sheet aligned by the aligning roller 1710. Then, the toner image transferred onto the paper sheet is fixed under heat by a fixing device 1705 to obtain a printed sheet. The printed surface of the sheet is selected to face upward or downward by a flapper 1712 and, then, forwarded into an upper tray 1714 or a side tray 1715 by a roller 1712 or 1713 for transferring the printed paper sheet. After the transfer step of the toner image onto the paper sheet, the bonding strength between the residual toner image and the photosensitive drum is weakened by a cleaning auxiliary brush 1703 and, then, the residual toner is removed simultaneously with the development performed by the developer 1707.

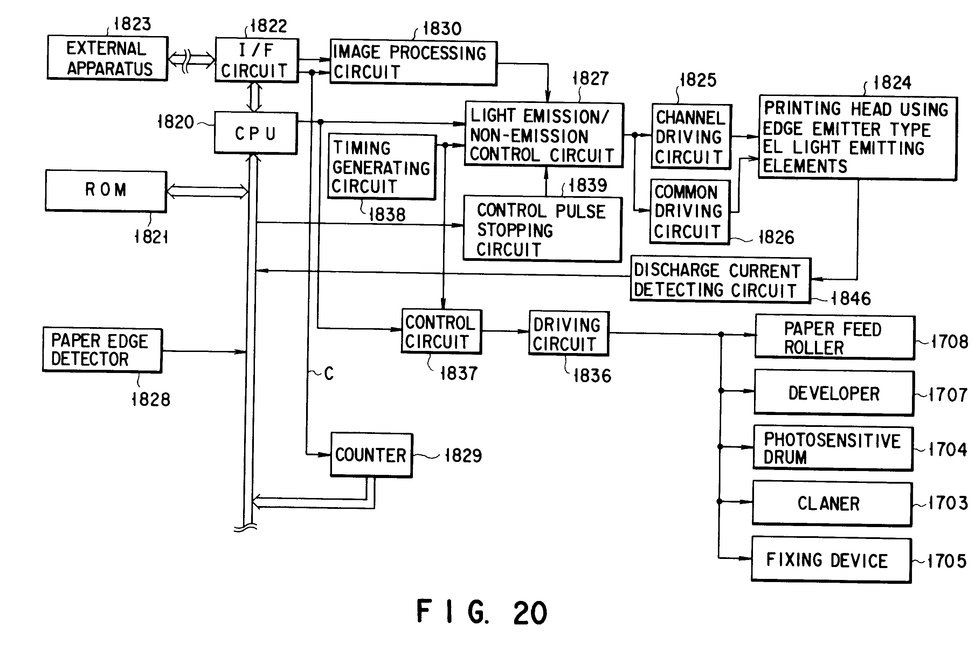

Fig. 20 shows the construction of the control section of the edge emitter type EL printer of the construction described above. As seen from the drawing, a CPU (central processing unit) 1820 serves to control the entire printer. A control program of the CPU 1820, a table data for designating the printing region, etc. are stored in a memory (ROM) 1821. An interface (I/F) circuit 1822 serves to perform communication between the printer and an external apparatus 1823 under the control by the CPU 1820. A channel driving circuit 1825 serves to selectively enable the light emitting elements of an edge emitter type EL light emitter array 1824, which is included in the printing head unit 1701 referred to previously, to emit light beams based on a control signal generated from a light emission/non-emission control circuit 1827. The control circuit 1827 also serves to selectively enable the EL light emitting elements to emit light beams based on an image data generated from an image processing circuit 1830. Further, the control signal generated from the control circuit 1827 is also supplied to a common driving circuit 1826 for applying a voltage to the common electrode of the EL head 1824. A reference numeral 1828 shown in Fig. 20 denotes a paper edge detector for detecting the edge of a paper sheet supplied to the printer.

A counter 1829 serves to count line synchronizing signals (horizontal synchronizing signals) C transferred from the external apparatus 1823 through the I/F circuit 1822. A timing generating circuit 1838 serves to generate clock signals for operating the light emission/non-emission control circuit 1827 and a control circuit 1837. A control pulse stopping circuit 1839 serves to take out a table data from the ROM 1821 with reference to the value of the counter 1829 so as to stop supplying a light emission control pulse to the printer head 1824 utilizing edge emitter type EL light emitting elements. Further, a discharge current detecting circuit 1840 serves to monitor the discharge current from at least two EL light emitting elements included in the edge emitter type EL light emitter array 1824, and the result of the detection is supplied to the CPU 1820.

A driving circuit 1836 serves to control the driving of each of the paper feed roller 1708, the developer 1707, the photosensitive drum 1704, the cleaning auxiliary brush 1703 and the fixing device 1705 shown in Fig. 19 on the basis of the control signal generated from the control circuit 1837.

Where an image data is not supplied from the external apparatus 1823 to the printer, the CPU 1820 supplies a command signal to the control pulse stopping circuit 1829 to stop supplying a light emission control signal to the edge emitter type EL light emitter array 1824. Upon receipt of a print starting command signal from the external apparatus 1823 via the I/F circuit 1822, the CPU 1820 drives the paper sheet feed roller 1708 so as to supply a paper sheet to the printer. When the paper edge detector 1828 detects the edge of the paper sheet, the CPU 1820 supplies a command signal to the external apparatus 1823 to cause the external apparatus to transfer the image data. At this stage, the CPU 1820 supplies a command signal to the control pulse stopping circuit 1839 to cease to stop supplying a light emission control pulse to the edge emitter type EL light emitter array 1824.

When an image data is supplied from the external apparatus 1823 in synchronism with the line synchronism signal C upon demand for transfer generated from the CPU 1820, the image data is processed in an image processing circuit 1830 and, then, is transferred to the light emission/non-emission control circuit 1827. At this stage, the CPU 1820 takes out data from the table of ROM 1821 and determines the position of the light emission starting picture element of the printing head 1824 using edge emitter type EL light emitting elements. Further, while controlling the driving pulse of the edge emitter type EL light emitter array 1824 after input of the line synchronism signal C within the light emission/non-emission control circuit 1827, the CPU 1820 further transfers the image data to the common driving circuit 1826 and the channel driving circuit 1825 so as to designate the write position of the image data on a printing paper, i.e., to designate the left end reference position for writing on the printing paper and the writing area.

In the next step, the timing generating circuit 1838 supplies a reference clock signal generated within the circuit 1839 in synchronism to the light emission/non-emission control circuit 1827 and the control circuit 1837. The light emission/non-emission control circuit 1827 receives a timing clock signal generated under the control of the CPU 1820 from the timing generating circuit 1838 in synchronism with the excited pulse of a pulse motor for driving the photosensitive drum, said pulse motor serving to control the printing position in the sub-scanning direction. Further, the data after the image processing, which is generated from the image processing circuit 1830, is transferred to the common driving circuit 1826 and the channel driving circuit 1825 in synchronism with the timing clock signal.

The common driving circuit 1826 generates a common pulse signal which is applied to the common electrodes of the EL print head 1824. On the other hand, the channel driving circuit 1825 generates a channel pulse signal which is applied to the channel electrodes of the EL print head 1824. Each of these common pulse signal and the channel pulse signal is supplied to the edge emitter type EL light emitter array 1824.

As described above, an excited pulse signal for a motor included in the driving system of the photosensitive drum, said excited pulse signal serving to control the printing position in the sub-scanning direction, is generated in synchronism with the light emission control pulse signal for the edge emitter type EL light emitter array 1824, with the result that it is possible to form a latent image, which permits reproducing the image data with a high fidelity, on the photosensitive drum 1704.

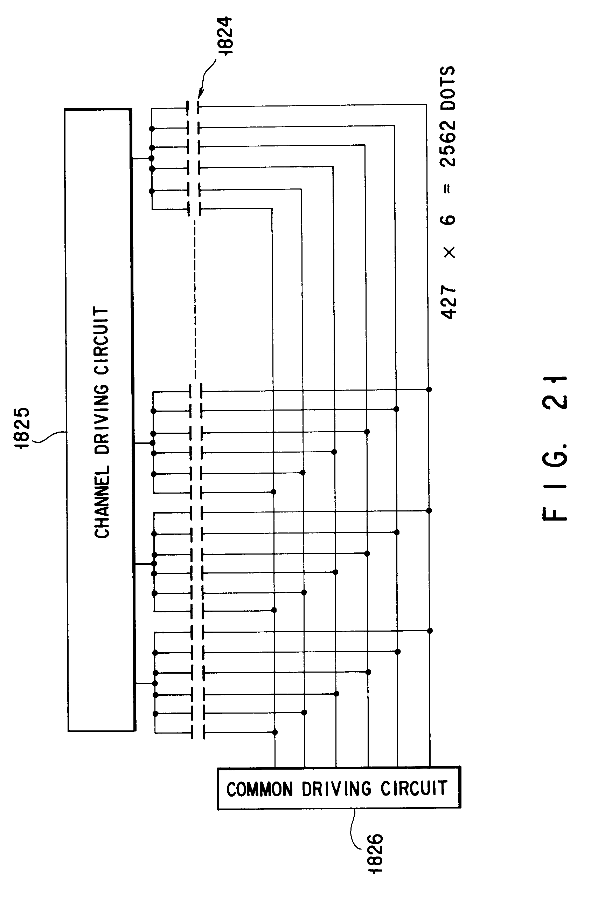

The picture elements (EL light emitting elements) included in the edge emitter type EL light emitter array 1824 are selectively allowed to emit light beams as described in the following. Specifically, Fig. 21 shows a driving circuit diagram for the printing head utilizing the edge emitter type EL light emitting elements. The edge emitter type EL light emitter array 1824 is of a matrix structure consisting of 6 common electrodes and 427 channel electrodes. The common electrodes are connected to a common driving circuit 1826. Likewise, the channel electrodes are connected to a channel driving circuit 1825 serving to control the light emission/non-emission of the light emitting elements.

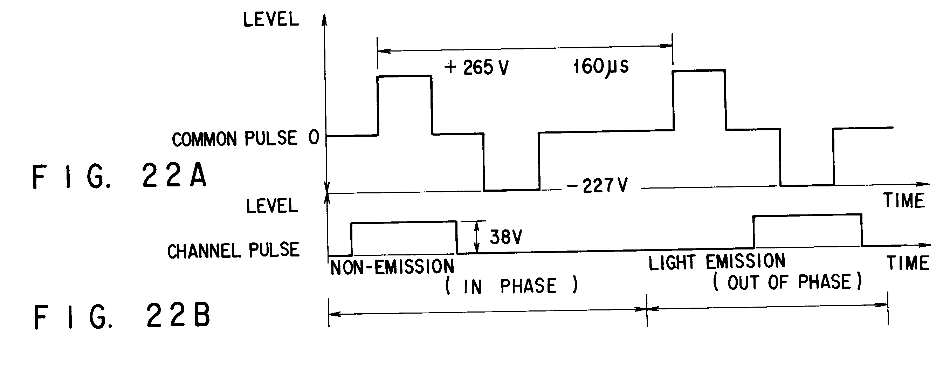

The common driving circuit 1826 comprises a high voltage switching circuit, i.e., a driving circuit for successively scanning a high voltage, and a distribution circuit for distributing the high voltage to the common electrodes. The light emission/non-emission is controlled by controlling the phases of the common pulse applied to the common electrodes and the channel pulse applied to the channel electrodes. As shown in Figs. 22A and 22B, a light beam is not emitted when the common pulse and the channel pulse are in phase, and a light beam is emitted when these pulse signals are out of phase.

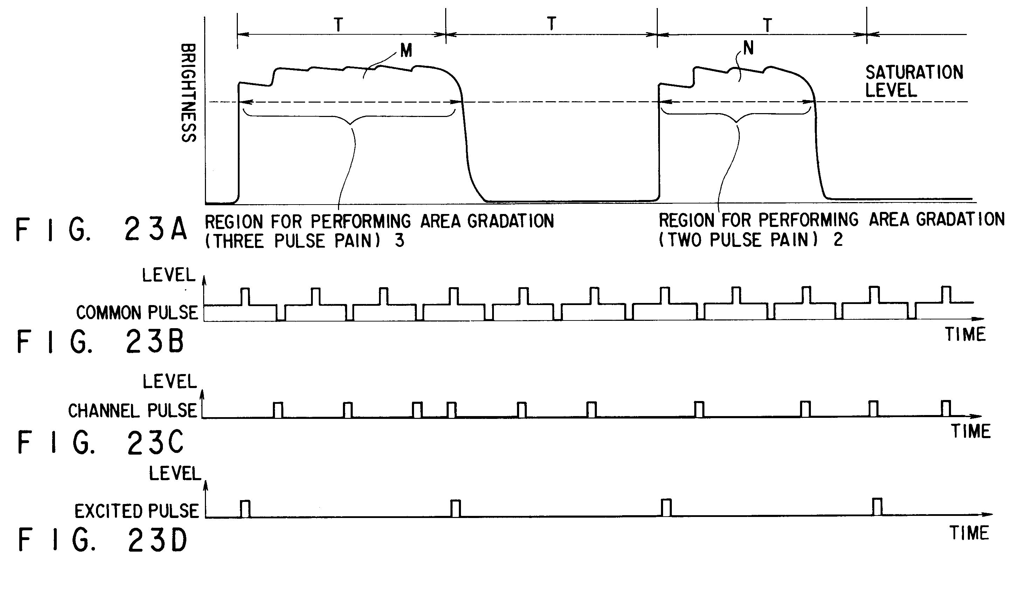

Figs. 23A to 23D collectively show the relationship among the common pulse, channel pulse and excited pulse for a motor included in the driving system of the photosensitive drum in respect of the light emission from the edge emitter type EL light emitter array 1824. As seen from these drawings, the distance between dots of printed picture image is maintained constant by keeping the light emission control pulse for the edge emitter type EL light emitter array 1824 in synchronism with the excited pulse for a motor included in the driving system of the photosensitive drum. It follows that it is possible to obtain a picture image of a quality higher than in the prior art.

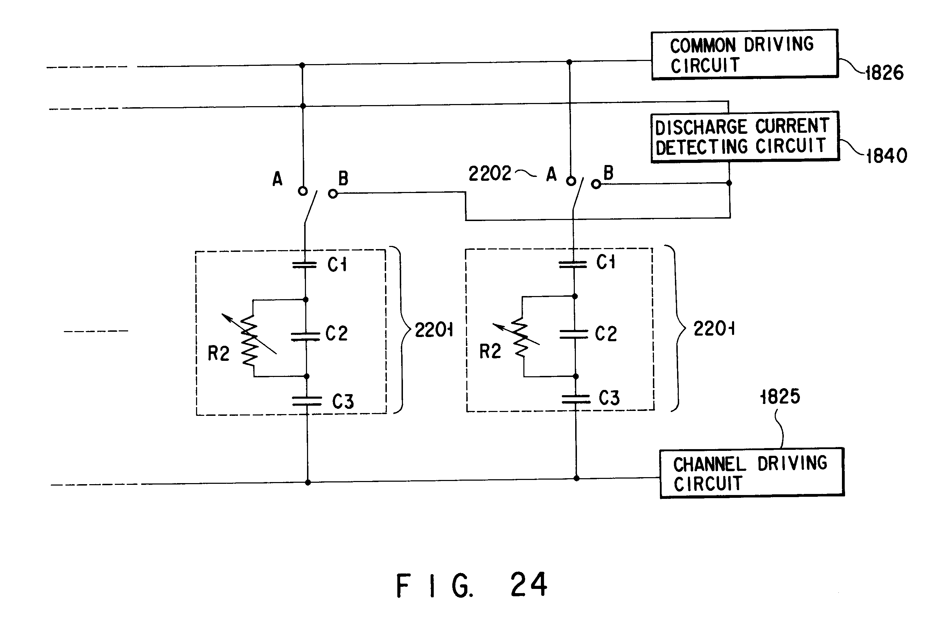

Fig. 24 is an equivalent circuit diagram for the EL light emitting elements included in the edge emitter type EL light emitter array 1824 and the discharge current detecting circuit 1840. An equivalent circuit 2201 for the EL light emitting element can be represented by capacitances $C1$, $C3$ for the dielectric layers, a capacitance $C2$ for the light emitting layer, and a nonlinear resistance $R2$ connected in parallel with the capacitance $C2$. The nonlinear resistance $R2$ exhibits an infinitely high resistance value when a voltage lower than the threshold value for the light emission is applied to the light emitting layer. However, the resistance value of the nonlinear resistance $R2$ becomes zero under a voltage higher than the threshold value. To be more specific, an electron avalanche phenomenon takes under a voltage higher than the threshold value, with the result that the portion corresponding to the capacitance $C2$ of the light emitting layer is caused to disappear. Further, polarization is brought about by the avalanche phenomenon within the light emitting layer.

The circuit shown in Fig. 24 comprises a change-over switch 2202 for detecting an input signal. When the switch 2202 is connected to a terminal B, the discharge current from the EL light emitting element is conducted from the equivalent circuit 2201 to the discharge current detecting circuit 1840, with the result that the discharge current from the EL light emitting element is detected by the detecting circuit 1840. If a voltage is applied to the common electrode and the channel electrode while the change-over switch 2202 is in contact with a terminal A, an electric field of a high intensity is applied to the dielectric layers and the light emitting layer so as to bring about a light emission. If the change-over switch 2202 is brought into contact with the terminal B by utilizing the time before the next light emission, a discharge current corresponding to the intensity of the emitted light beam is detected by the discharge current detecting circuit 1840. If the edge emitter type EL light emitting element is deteriorated to be incapable of maintaining the initial intensity of the light emission, a message to that effect is displayed on a display section (not shown) on the basis of information generated from the discharge current detecting circuit 1840.

As described above, the detection of the discharge current from the edge emitter type EL light emitting element enables a user of the printer to be informed of the necessity of replacing the edge emitter type EL light emitting element. In this case, an optical system for detecting the intensity of the light beam emitted from the edge emitter type EL light emitting element need not be added to the system.

The above description covers a single EL light emitting element included in the printing head 1824, said element forming a segment. However, the light intensity can be detected for all of the EL light emitting elements including the printing region by successively switching the input detection change-over switch 2202.

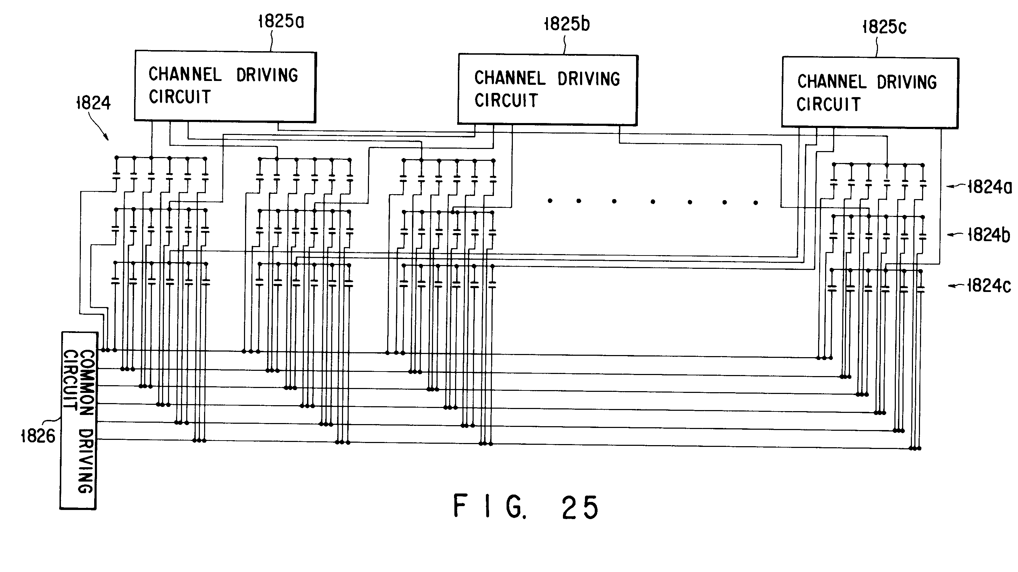

Fig. 25 shows a driving circuit for the printing head utilizing the edge emitter type EL light emitting elements shown in Figs. 10, 11. The edge emitter type EL light emitter array 1824 is of a matrix structure consisting of first to third groups of 6 common electrodes and first to third groups of 427 channel electrodes, since each of the EL elements 1824a, 1824b and 1824c consists of three segments each having the common electrode and the channel electrodes as shown in Figs. 10 and 11. The first to third groups of common electrodes are connected to a common driving circuit 1826.

The first to third groups of channel electrodes are connected to channel driving circuit 1825a, 1825b and 1825c, respectively, serving to control the light emission/non-emission of the light emitting elements.

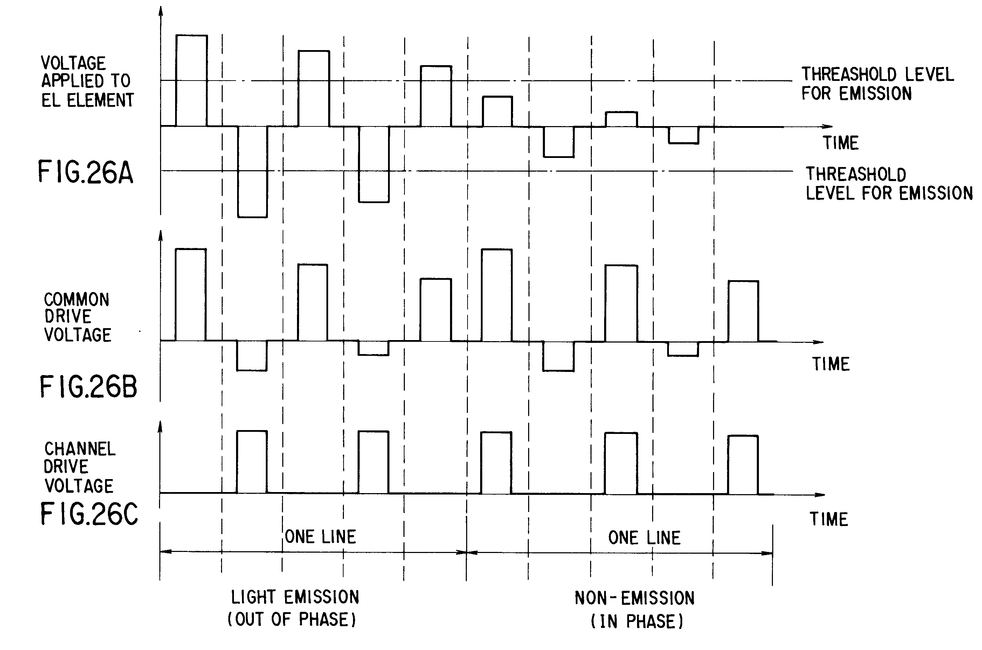

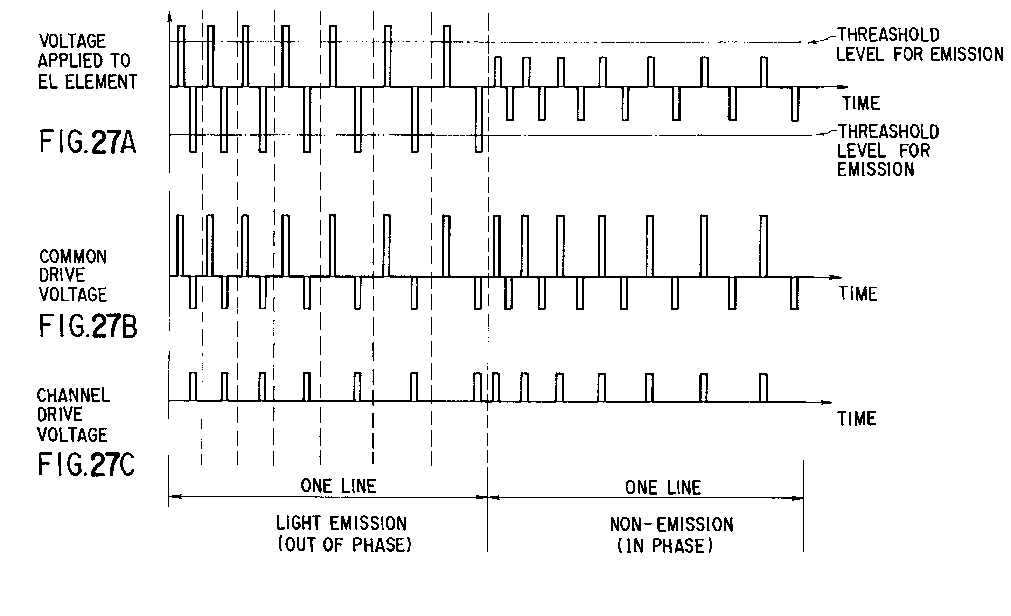

The common driving circuit 1826 comprises a high voltage switching circuit, i.e., a driving circuit for successively scanning a high voltage, and a distribution circuit for distributing the high voltage to the common electrodes. The light emission/non-emission is controlled by controlling the phases of the common pulse shown in Fig. 15 or Fig. 16, which is applied to the common electrodes and the channel pulse applied to the channel electrodes. As shown in Figs. 26A to 26C and 27A to 27C which correspond to Figs. 15 and 16, respectively, a light beam is not emitted when the common pulse and the channel pulse are in phase, and a light beam is emitted when these pulse signals are out of phase.

As described above, it is possible in the present invention to improve the light intensity distribution in the main scanning direction of the edge emitter type EL light emitter array by detecting the light intensity for each of the edge emitter type EL light emitting elements which are formed as segments so as to control the voltage applied to the edge emitter type EL light emitting elements. It is also possible to correct similarly the changes with time in the characteristics of the edge emitter type EL light emitting element, as described previously.

To be more specific, the present invention makes it possible to apply a suitable control by detecting the intensity of the light beam emitted from an edge emitter type EL light emitting element which directly affects the printing operation, unlike the conventional method in which a light sensor is arranged on a photosensitive body. What should also be noted is that, in the conventional method using a light sensor, it is difficult to measure accurately the light intensity in the case where the detecting section of the light sensor is contaminated by the scattering of the developing agent, giving rise to the problem that an excessively high voltage is applied to the EL light emitting element. However, the image forming apparatus of the present invention permits overcoming the particular problem.

As described above in detail, prominent effects can be obtained in the present invention, as summarized below:

1. The uniformity of the light intensity in the main scanning direction of the printing head, in which an edge emitter type EL light emitter array is incorporated, can be improved under the added state of a Selfoc lens array on the basis of the data measured or calculated in advance.

2. Since it is possible to adjust the light intensity in the process of forming an edge emitter type EL printing head, it is unnecessary to apply an after-treatment to the edge emitter type EL printing head. Thus, the forming process can be markedly shortened, leading to a cost reduction.

3. The nonuniform light intensity distribution can be improved with a high accuracy by adding to the apparatus a mechanism for adjusting the relative positions of the Selfoc lens array and the edge emitter type EL printing head in the main scanning direction. For example, it is possible to prevent the nonuniformity in the light intensity distribution from being amplified by the coincidence of the phase in the light intensity distribution of the edge emitter type EL printing head after correction of the light intensity with the phase in the nonuniformity of the light intensity distribution of the Selfoc lens array. Further, it suffices for the amount of the relative movement to be smaller than the pitch of the nonuniformity in the light intensity distribution of the Selfoc lens array.

4. The nonuniformity in the light intensity distribution caused by the Selfoc lens array can be improved by forming an optical filter on a common plane of adjacent Selfoc lenses, making it unnecessary to adjust the light intensity in the process of preparing an edge emitter type EL printing head.

5. An optical element for correcting the nonuniform light intensity, which is arranged on the optical axis of the Selfoc lens lens, can be eliminated by forming a protective layer for ensuring the environmental resistance of the edge emitter type EL light emitting element such that the protective layer exhibits a light transmittance effective for correcting the nonuniform light intensity of the Selfoc lens array.

6. The edge emitter type EL light emitting element is enabled to start its light emission with a low voltage. In addition, a predetermined light intensity can be obtained in the intermediate layer. It follows that it is possible to improve the rising characteristics of the edge emitter type EL light emitting element.

7. A light emission with a strong directionality can be obtained by shaping the light emitting layer of the edge emitter type EL light emitting element such that the thickness of the light emitting layer is gradually diminished toward the light emitting edge surface, leading to an improved light emission efficiency.

8. Where the edge emitter type EL light emitting element is divided into three portions, i.e., a light emission starting layer for starting the light emission, an intermediate light emission layer for obtaining a required light intensity, and an edge light emitting layer for collecting the emitted light, it is possible to obtain simultaneously improved rising characteristics of the light emission, a required light intensity and a high light emission efficiency.

9. Where voltages corresponding to the thicknesses in the divided portions of the light emitting layer are applied to the edge emitter type EL light emitting element, it is possible to prevent the light emitting layer from being broken. Also, a light emission with a high efficiency can be obtained by applying a voltage corresponding to the thickness of the light emitting layer.

10. The light waveguide phenomenon can be made efficient by making the voltages applied to the light emission starting portion, to the intermediate light emission portion, and to the light emitting edge portion of the light emitting layer of the edge emitter type EL light emitting element equal to each other in phase, making it possible to obtain a light emission of a high intensity.

11. The power consumption can be saved by applying voltages V1, V2 and V3 successively to the edge edge emitter type EL light emitting element, said V1, V2 and V3 representing the voltages applied to the light emission starting portion, to the intermediate light emission portion, and to the light emitting edge portion of the light emitting layer of the edge emitter type EL light emitting element, respectively.

12. The rising characteristics of the light emission can be improved by keeping voltage V1 alone applied, compared with the case of applying voltages V1, V2 and V3 successively to the edge edge emitter type EL light emitting element, said V1, V2 and V3 representing the voltages applied to the light emission starting portion, to the intermediate light emission portion, and to the light emitting edge portion of the light emitting layer of the edge emitter type EL light emitting element, respectively.

13. It is possible to make the rising characteristics of the brightness of the edge emitter type EL light emitting element sharper than that at the starting time of the light emission from the edge emitter type EL light emitting element. This makes it possible to ensure easily the saturated region of the brightness, leading to an improved printing quality.

14. It is possible to sharpen the rising characteristics of the brightness of the edge emitter type EL light emitting element without changing the voltage applied to the edge emitter type EL light emitting element. This makes it possible to use a single type of the power source voltage and, thus, to prepare the driving circuit at a lower cost.

15. It is possible to keep constant the distance between adjacent lines of the printed images by controlling the light emission control pulse for the edge emitter type EL light emitting element to be in synchronism with the excited pulse for a pulse motor for driving a photosensitive drum, leading to an improved quality of the printed document. Particularly, it is possible to suppress effectively the nonuniform concentration in the expression of the intermediate gradation.

16. The deterioration and the state of the after of the edge emitter type EL light emitting element can be detected by monitoring the discharge current from the edge emitter type EL light emitting element without separately providing a light detecting element for detecting the intensity of the emitted light beam. It is also possible to inform a user of the printer of the necessity of renewing the edge emitter type EL light emitting element by displaying the deterioration with time of the edge emitter type EL light emitting element based on the result of the detection.

17. It is possible to detect the intensity of the light beam emitted from an edge emitter type EL light emitting element, which is in the form of a segment and affects the actual printing operation, unlike the conventional apparatus in which a light sensor is arranged on the surface of a photosensitive drum. It follows that it is possible to correct the light intensity distribution in the main scanning direction of the printing head.

18. In the conventional apparatus using a light sensor arranged on the surface of a photosensitive drum, the light intensity detected by the light sensor is affected by the scattering of a developing agent. To be more specific, the detected light intensity is lower than the actual intensity of the light beam, with the result that an excessively high voltage is applied to the edge emitter type EL light emitting element. However, the apparatus of the present invention permits overcoming the above-noted difficulty inherent in the prior art, and also permits controlling accurately the light intensity after deterioration with time of the edge emitter type EL light emitting element.

The present invention is not restricted to the embodiments described above. Needless to say, the technical idea of the present invention can be realized in the form of various modifications.

As described above in detail, the present invention provides an image forming apparatus which permits improving the light intensity distribution in the main scanning direction including the nonuniform light intensity derived from the optical means such as a Selfoc lens array.

The present invention also provides an image forming apparatus which permits improving the rising characteristics of the light emission from the edge emitter type element.

Further, the present invention provides an image forming apparatus which permits detecting the deterioration of the edge emitter type element and also permits correcting the light intensity caused by the deterioration.

**Claims**

1. An image forming apparatus for forming an image on an image bearing member (1704), characterized by comprising:

   optical guide means (404, 504) for guiding a light beam to the image bearing member (1704) so as to irradiate a linear region of the image bearing member (1704), said optical guide means (404, 504) having light transmitting characteristics which permit said linear region to be irradiated with a first periodic and nonuniform light intensity distribution; and

   means (10) for emitting the light beam so as to irradiate said optical guide means (404, 504), said emitting means (10) having a plurality of edge emitter type light emitting elements (11a-11g, 21a-21g) which are linearly arranged and emit light from the edge surface on the basis of an electroluminescence phenomenon toward said guide means (404, 504), for emitting a light beam of a second periodic and nonuniform intensity dependent on said first intensity distribution so as to achieve a substantially uniform light intensity distribution in the linear region of the image bearing member (1704).

2. An image forming apparatus for forming an image on an image bearing member (1704), characterized by comprising:

   optical guide means (404, 504) for guiding a beam to the image bearing member (1704) so as to irradiate a linear region of the image bearing member (1704), said optical guide means (404, 504) having light transmitting characteristics which permit said linear region to be irradiated with a light intensity distribution having a nonuniform period;

   means (10) for emitting the light beam so as to irradiate said optical guide means (404, 504), said emitting means (10) having a plurality of edge emitter type light emitting elements (11a-11g, 21a-21g) which are linearly arranged and emit light from the edge surface on the basis of an electroluminescence phenomenon toward said guide means (1704); and

   means (514, 612) for transmitting the light beams guided by said optical guide means (404, 504) so as to correct the nonuniform light intensity distribution of said optical guide means (404, 504).

3. The image forming apparatus according to claim 2, characterized in that said light transmitting means (514, 612) comprises a protective film (612) serving to shield said edge emitter type light emitting element (11a-11g, 21a-21g) from an outer atmosphere, the light transmittance of the protective film (612) on the side of said edge emitter type light emitting element (11a-11g, 21a-21g) being determined to correct the nonuniformity in the light intensity distribution of said guide means (404, 504).

4. The image forming apparatus according to claim 1 or 2, characterized in that each of said edge emitter type light emitting elements (11a-11g, 21a-21g) comprises:

   a light emitting layer (12a-12g) for emitting a light beam, said light emitting layer (12a-12g) consisting of a first segment having a first thickness T1 and serving to start the light emission, and a second segment having a second thickness T2 larger than said first thickness T1 and and positioned closer to the light emitting edge surface than said first segment;

   a first electrode (14a-14g) mounted on the light emitting layer to apply an electric field to said first segment; and

   a second electrode (15a-15g) mounted on the light emitting layer to apply an electric field to said second segment.

5. The image forming apparatus according to claim 4, characterized by further comprising means (1825, 1826) for applying voltage to the light emitting layer such that a first voltage is applied to said first electrode (14a-14g) in starting a light emission from the edge emitter type light emitting element (11a-11g, 21a-21g), followed by applying a second voltage to said second electrode.

6. The image forming apparatus according to claim 1 or 2, characterized in that each of said edge emitter type light emitting element (11a-11g, 21a-21g) comprises a light emitting layer (12a-12g, 22a-22g) for emitting a light beam and electrode means (14a-14g, 15a-15g, 24a-24g, 25a-25g) for applying an electric field to said light emitting layer (12a-12g, 22a-22g).

7. The image forming apparatus according to claim 6, characterized in that said electrode means (14a-14g, 15a-15g, 24a-24g, 25a-25g) serves to apply pulse voltages V1, V2, ... Vn successively to the light emitting layer (12a-12g, 22a-22g) until a peak is reached in the intensity of the emitted light beam, said voltages V1, V2, ... Vn being $V1 \geq V2 \geq ... \geq Vn$.

8. The image forming apparatus according to claim 6, characterized in that said electrode means (14a-14g, 15a-15g, 24a-24g, 25a-25g) serves to apply pulse voltages V1, V2, ... Vn successively to the light emitting layer (12a-12g, 22a-22g) until a peak is reached in the intensity of the emitted light beam, said voltages V1, V2, ... Vn having periods T1, T2, ... T3, said periods being $T \leq T2 \leq ... \leq Tn$.

9. The image forming apparatus according to claim 1 or 2, characterized by further comprising:

detecting means (1846) for detecting the intensity of a light beam emitted from said edge emitter type light emitting element (11a-11g, 21a-21g) on the basis of a discharge current generated from the edge emitter type light emitting element (11a-11g, 21a-21g); and

means (1820, 1821) for informing a user of the necessity of renewing said edge emitter type light emitting element (11a-11g, 21a-21g) where the light intensity detected by said detecting means is found to have been deteriorated.

10. The image forming apparatus according to claim 9, characterized by further comprising correcting means (1827) for correcting the light intensity of each of a plurality of said edge emitter type light emitting elements (11a-11g, 21a-21g) which are linearly arranged to form said emitting means (10) based on the light intensity detected by said detecting means (1846).

11. The image forming apparatus according to claim 9, characterized by further comprising correcting means (1827) for correcting a change with time in the light intensity of said edge emitter type light emitting element (11a-11g, 21a-21g), which is caused by a change with time in the edge emitter type light emitting element (11a-11g, 21a-21g), based on the light intensity detected by said detecting means (1846).

F I G. 1 A

F I G. 1 B

LIGHT INTENSITY DISTRIBUTION IN MAIN SCANNING DIRECTION OF EDGE EMITTER TYPE EL ELEMENT

DISTANCE

F I G. 1 C

LIGHT INTENSITY DISTRIBUTION OF SELFOC LENS ARRAY

DISTANCE

F I G. 1 D

LIGHT INTENSITY DISTRIBUTION IN MAIN SCANNING DIRECTION ON IMAGE-FORMING PLANE

DISTANCE

EP 0 571 737 A1

F I G. 2 A

F I G. 2 B    LIGHT INTENSITY DISTRIBUTION IN MAIN SCANNING    DISTANCE
DIRECTION OF EDGE EMITTER TYPE EL ELEMENT

F I G. 2 C    LIGHT INTENSITY DISTRIBUTION OF    DISTANCE
SELFOC LENS ARRAY

F I G. 2 D    LIGHT INTENSITY DISTRIBUTION IN MAIN SCANNING    DISTANCE
DIRECTION ON IMAGE-FORMING PLANE

EP 0 571 737 A1

F I G. 3A

11g  11f  11e  10  11d  11c  11b  11a

12g  12f  12e  12d  12c  12b  12a

F I G. 3B

$\Delta E$

LIGHT INTENSITY DISTRIBUTION IN MAIN SCANNING DIRECTION OF EDGE EMITTER TYPE EL ELEMENT       DISTANCE

F I G. 3C

$\Delta E$

LIGHT INTENSITY DISTRIBUTION OF SELFOC LENS ARRAY       DISTANCE

F I G. 3D

$\Delta E$

LIGHT INTENSITY DISTRIBUTION IN MAIN SCANNING DIRECTION ON IMAGE-FORMING PLANE       DISTANCE

EP 0 571 737 A1

FIG. 4A

11g  11f  11e  10  11d 11c  11b  11a

12g  12f  12e  12d  12c  12b  12a

FIG. 4B

$\Delta E$

LIGHT INTENSITY DISTRIBUTION IN MAIN SCANNING DISTANCE
DIRECTION OF EDGE EMITTER TYPE EL ELEMENT

FIG. 4C

$\Delta E$

LIGHT INTENSITY DISTRIBUTION OF SELFOC DISTANCE
LENS ARRAY

FIG. 4D

$\Delta E$

LIGHT INTENSITY DISTRIBUTION IN MAIN SCANNING DISTANCE
DIRECTION ON IMAGE-FORMING PLANE

EP 0 571 737 A1

F I G. 5

F I G. 6A

F I G. 6B

FIG. 7A

FIG. 7B

FIG. 8A

LIGHT INTENSITY DISTRIBUTION OF SELFOC LENS ARRAY

FIG. 8B

LIGHT TRANSMISSION DISTRIBUTION OF FILTER

F I G. 9

F I G. 11

F I G. 10

EP 0 571 737 A1

VOLTAGE A

F I G. 1 2A

TIME

VOLTAGE B

F I G. 1 2B

TIME

VOLTAGE C

F I G. 1 2C

TIME

LIGHT
INTENSITY

F I G. 1 2D

TIME

F I G. 1 3

VOLTAGE A

F I G. 14A

VOLTAGE B

F I G. 14B

LIGHT INTENSITY

F I G. 14C

BLIGHTNESS

SATURATION LEVEL

COMMON PULSE WAVEFORM

TIME

F I G. 15

F I G. 16

VOLTAGE-BRIGHTNESS CHARACTRISTICS

F I G. 17

FREQUENCY-BRIGHTNESS CHARACTRISTICS

F I G. 18

F I G. 19

F I G. 20

EP 0 571 737 A1

EP 0 571 737 A1

CHANNEL DRIVING CIRCUIT

1825

1824

COMMON DRIVING CIRCUIT

1826

427 × 6 = 2562 DOTS

F I G. 21

EP 0 571 737 A1

FIG. 22A

FIG. 22B

LEVEL

COMMON PULSE 0

+265 V    160 μs

−227V

TIME

LEVEL

CHANNEL PULSE

38V

NON-EMISSION
( IN PHASE )

LIGHT EMISSION
( OUT OF PHASE )

TIME

EP 0 571 737 A1

F I G.  2 3A

REGION FOR PERFORMING AREA GRADATION
(THREE PULSE PAIN) 3

REGION FOR PERFORMING AREA GRADATION
(TWO PULSE PAIN) 2

F I G.  2 3B

F I G.  2 3C

F I G.  2 3D

F I G. 24

COMMON DRIVING CIRCUIT 1826

DISCHARGE CURRENT DETECTING CIRCUIT 1840

CHANNEL DRIVING CIRCUIT 1825

2201

2202

C1 C2 C3

R2

A B

EP 0 571 737 A1

1825a

1825b

1825c

CHANNEL DRIVING
CIRCUIT

CHANNEL DRIVING
CIRCUIT

CHANNEL DRIVING
CIRCUIT

1824

1824a

1824b

1824c

COMMON DRIVING
CIRCUIT

1826

F I G. 25

VOLTAGE
APPLIED TO
EL ELEMENT

THRESHOLD LEVEL
FOR EMISSION

TIME

FIG.26A

THRESHOLD
LEVEL FOR EMISSION

COMMON
DRIVE
VOLTAGE

TIME

FIG.26B

CHANNEL
DRIVE
VOLTAGE

TIME

FIG.26C

ONE LINE

ONE LINE

LIGHT EMISSION
(OUT OF PHASE)

NON-EMISSION
(IN PHASE)

EP 0 571 737 A1

VOLTAGE
APPLIED TO
EL ELEMENT

THRESHOLD
LEVEL FOR EMISSION

TIME

FIG.27A

THRESHOLD
LEVEL FOR
EMISSION

COMMON
DRIVE
VOLTAGE

TIME

FIG.27B

CHANNEL
DRIVE
VOLTAGE

TIME

FIG.27C

ONE LINE

ONE LINE

LIGHT EMISSION
(OUT OF PHASE)

NON-EMISSION
(IN PHASE)

EP 0 571 737 A1

European Patent
Office

**EUROPEAN SEARCH REPORT**

Application Number

EP 93 10 4876

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 980 701 (CONTOIS ET AL.) | 1,2 | G 06 K 15/12 |
| Y | * column 3, line 3 - line 60; claim 1 * | 3 | B 41 J 2/45 |
| | --- | | H 01 L 33/00 |
| Y | GB-A-2 079 049 (PITNEY BOWES INC) | 3 | H 03 K 3/017 |
| A | * page 1, line 77 - line 97 * | 1,2 | |
| | ----- | | |

TECHNICAL FIELDS
SEARCHED (Int. Cl.5)

G 06 K
B 41 J
H 01 L
H 03 K

~~The present search report has been drawn up for all claims~~

| Place of search | Date of completion of the search | Examiner |
|---|---|---|
| THE HAGUE | 17-06-1993 | VEEN G E |

European Patent

Office

---

## CLAIMS INCURRING FEES

The present European patent application comprised at the time of filing more than ten claims.

☐ All claims fees have been paid within the prescribed time limit. The present European search report has been drawn up for all claims.

☐ Only part of the claims fees have been paid within the prescribed time limit. The present European search report has been drawn up for the first ten claims and for those claims for which claims fees have been paid,

namely claims:

☐ No claims fees have been paid within the prescribed time limit. The present European search report has been drawn up for the first ten claims.

---

## LACK OF UNITY OF INVENTION

The Search Division considers that the present European patent application does not comply with the requirement of unity of invention and relates to several inventions or groups of inventions,

namely:

### See sheet -B-

☐ All further search fees have been paid within the fixed time limit. The present European search report has been drawn up for all claims.

☐ Only part of the further search fees have been paid within the fixed time limit. The present European search report has been drawn up for those parts of the European patent application which relate to the inventions in respect of which search fees have been paid,

namely claims:

☒ None of the further search fees has been paid within the fixed time limit. The present European search report has been drawn up for those parts of the European patent application which relate to the invention first mentioned in the claims.

namely claims:     1 – 3

European Patent
Office

EP 93 10 4876 -B-

1. Claims 1-3: Led array with corrective filter achieving uniform light distribution

2. Claims 4,5: Electroluminescent elements divided in two segments, to which two different voltages are applied

3. Claims 6,7,8: Application of pulses, increasing in amplitude or voltage, until light intensity reaches peak

4. Claims 9,10,11: Feedback loop controlling intensity